# EUROPEAN PATENT APPLICATION

(11) **EP 4 832 691 A2**
(43) Date of publication of application: **28.10.2026**
(21) Application number: 26171544.5
(22) Date of filing: 09.04.2026
(51) Int. Cl.: H10D 89/10, G06F 30/392, H10D 84/90

(54) **INTEGRATED CIRCUIT INCLUDING STANDARD CELLS AND METHOD OF DESIGNING THE SAME**

(30) Priority: 24.04.2025 KR 20250053971; 28.08.2025 KR 20250121019
(71) Applicant: Samsung Electronics Co., Ltd., Suwon-si, Gyeonggi-do 16677 (KR)
(72) Inventor: YU, Jisu, 16677 Suwon-si (KR); CHO, Jaehee, 16677 Suwon-si (KR); JEONG, Minjae, 16677 Suwon-si (KR); DO, Jungho, 16677 Suwon-si (KR); NAM, Geonwoo, 16677 Suwon-si (KR)
(74) Representative: Marks & Clerk LLP

(57) **Abstract**

An integrated circuit includes a first cell disposed in a first row having a first width, the first cell including a first active pattern (AP) and a second AP, a second cell disposed in a second row having a second width different from the first width and being adjacent to the first row, the second cell including a third AP and a fourth AP, and a third cell disposed consecutively in the first row and the second row. The third cell may include a fifth AP having a greater width than a width of each of the first AP and the second AP in the first row, and a sixth AP having a greater width than a width of each of the third AP and the fourth AP in the second row.

## Description

### BACKGROUND

An integrated circuit for processing digital signals may include a large number of standard cells. With the advancement of semiconductor processes, the physical dimensions of standard cells may decrease, thereby improving the density of standard cells incorporated within a single integrated circuit. To meet requirements such as high performance, high density, and low power consumption, an integrated circuit may include standard cells having various structural configurations and spatial layouts.

### SUMMARY

Various implementations of this disclosure relate to an integrated circuit and, more particularly, to an integrated circuit including standard cells and a method of designing the same. An aspect provides an integrated circuit that meets various requirements and a method of designing the same.

According to an aspect, an integrated circuit includes a first cell disposed in a first row and including a first active pattern (AP) and a second AP extending in a first direction, the first row having a first width and extending in the first direction; a second cell disposed in a second row and including a third AP and a fourth AP extending in the first direction, the second row having a second width different from the first width, being adjacent to the first row in a second direction intersecting the first direction, and extending in the first direction; and a third cell disposed consecutively in the first row and the second row, wherein the third cell may include a fifth AP having a greater width than each of the first AP and the second AP and extending in the first direction in the first row; and a sixth AP having a greater width than each of the third AP and the fourth AP and extending in the first direction in the second row.

According to an aspect, an integrated circuit includes a first cell disposed in a first row and including a first AP and a second AP extending in the first direction, the first row having a first width and extending in a first direction; a second cell disposed in a second row and including a third AP and a fourth AP extending in the first direction, the second row having a second width different from the first width, being adjacent to the first row in a second direction intersecting the first direction, and extending in the first direction; and a third cell disposed consecutively in the first row and the second row, the third cell including a fifth AP overlapping the first AP in the first direction and extending in the first direction, wherein the second AP and the third AP may each extend in the first direction between the first AP and the fourth AP, and the fifth AP is spaced apart by a first distance from a boundary of the first row in the second direction, the first AP is spaced apart by a second distance from the boundary of the first row in the second direction, and the first distance is greater than the second distance.

According to an aspect, an integrated circuit includes a first cell disposed in a first row having a first width and extending in a first direction; a second cell disposed in a second row having a second width different from the first width, being adjacent to the first row in a second direction intersecting the first direction, and extending in the first direction; a third cell disposed in a third row having the first width, being adjacent to the second row in the second direction, and extending in the first direction; and a fourth cell disposed consecutively in the first row, the second row, and the third row, the fourth cell including a first AP extending in the first direction on a boundary between the first row and the second row and a second AP extending in the first direction on a boundary between the second row and the third row, wherein each of the first AP and the second AP may have a greater width than an AP included in each of the first cell, the second cell and the third cell.

At least some of the above and other features of the invention are set out in the claims.

### BRIEF DESCRIPTION OF THE DRAWINGS

These and/or other aspects, features, and advantages of the present disclosure will become apparent and more readily appreciated from the following description of example implementations.
FIG. 1 is a diagram illustrating an integrated circuit according to an implementation.
FIGS. 2A, 2B, 2C, and 2D are views illustrating examples of devices according to some implementations.
FIGS. 3A and 3B are diagrams illustrating examples of layouts of integrated circuits according to some implementations.
FIGS. 4A and 4B are diagrams illustrating examples of layouts of integrated circuits according to some implementations.
FIGS. 5A and 5B are diagrams illustrating examples of layouts of integrated circuits according to some implementations.
FIGS. 6A, 6B, 6C, and 6D are diagrams illustrating examples of layouts of integrated circuits according to some implementations.
FIGS. 7A, 7B, 7C, and 7D are diagrams illustrating examples of layouts of integrated circuits according to some implementations.
FIGS. 8A, 8B, and 8C are diagrams illustrating examples of layouts of integrated circuits according to some implementations.
FIGS. 9A and 9B are diagrams illustrating examples of layouts of integrated circuits according to some implementations.
FIG. 10 is a diagram illustrating circuits included in an integrated circuit according an implementation.
FIGS. 11A and 11B are views illustrating examples of a layout of an integrated circuit according to some implementations.
FIG. 12 is a flowchart illustrating a method of manufacturing an integrated circuit according to an implementation.
FIG. 13 is a block diagram illustrating a system-on-chip (SoC) according to an implementation.
FIG. 14 is a block diagram illustrating a computing system including a memory configured to store a program according to an implementation.

### DETAILED DESCRIPTION

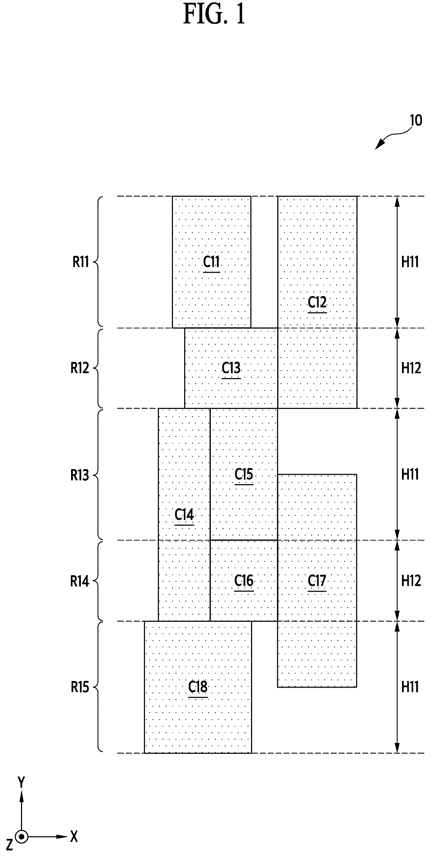

FIG. 1 is a diagram illustrating an integrated circuit 10 according to an implementation. For example, FIG. 1 illustrates the integrated circuit 10 on a plane defined by an X-axis and a Y-axis. In the present disclosure, the X-axis direction and the Y-axis direction may be referred to as a first direction and a second direction, respectively, and the Z-axis direction may be referred to as a vertical direction or a third direction. The plane defined by the X-axis and the Y-axis may be referred to as a horizontal plane, a component disposed relatively in the +Z direction with respect to another component may be referred to as being above the other component, and a component disposed relatively in the -Z direction with respect to another component may be referred to as being below the other component. In addition, an area of a component may refer to a size occupied by the component in a plane parallel to the horizontal plane, and a width of a component may refer to a length in a direction orthogonal to the direction in which the component extends. A surface exposed in the +Z direction may be referred to as a top surface, a surface exposed in the -Z direction may be referred to as a bottom surface, and a surface exposed in the ±X direction or the ±Y direction may be referred to as a side surface.

In the drawings of the present disclosure, for ease of illustration, only some layers may be shown, and vias connecting an upper pattern and a lower pattern may be illustrated for better understanding even though the vias are located below the upper pattern. For ease of illustration, a gate shown as an integral body may be separated into two or more gates by at least one gate cut. A pattern formed of a conductive material, such as a pattern of a wiring layer, may be referred to as a conductive pattern, or simply as a pattern. In the present disclosure, components that are electrically connected to each other may be simply referred to as components connected to each other.

The integrated circuit 10 may include cells. A cell may be referred to as a standard cell, as a unit of layout included in an integrated circuit. The cell may include a device, for example, a transistor, and may be designed to perform a predefined function. As illustrated in FIG. 1, the integrated circuit 10 may include first to eighth cells C11 to C18. In an integrated circuit, cells may be arranged in a series of rows. For example, as illustrated in FIG. 1, first to fifth rows R11 to R15 may extend in the X-axis direction, and the first to eighth cells C11 to C18 may be arranged in the first to fifth rows R11 to R15. A width, i.e., a length in the Y-axis direction, of a row extending in the X-axis direction may be referred to as a height. A cell disposed in a single row, like the first cell C11, the third cell C13, the fifth cell C15, the sixth cell C16, and the eighth cell C18, may be referred to as a single-height cell. In addition, a cell disposed in two or more consecutive rows, like the second cell C12, the fourth cell C14, and the seventh cell C17, may be referred to as a multi-height cell.

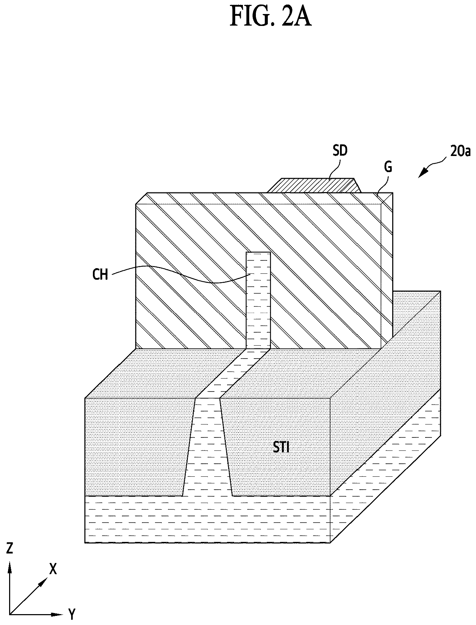

In some implementations, cells may be arranged in rows having different heights. For example, as illustrated in FIG. 1, the first row R11, the third row R13, and the fifth row R15 may have a first height H11, whereas the second row R12 and the fourth row R14 may have a second height H12 smaller than the first height H11. Cells having the first height H1, like the first cell C11, the fifth cell C15, and the eighth cell C18, may include devices having higher current driving capabilities than devices included in cells having the second height H12, like the third cell C13 and the sixth cell C16. Examples of the devices will be described later with reference to FIGS. 2A through 2D. Cells having the first height H11 may provide higher performance than cells having the second height H12 and may be referred to as high-performance (HP) cells in the present disclosure. Cells having the second height H12 may have a smaller area than cells having the first height H11 and may be referred to as high-density (HD) cells in the present disclosure. In some implementations, the integrated circuit 10 may also include cells disposed in rows having three or more different heights. In the present disclosure, a structure in which cells are disposed in rows having different heights may be referred to as a mixed-row structure.

In some implementations, the integrated circuit 10 may include multi-height cells disposed consecutively in rows having different heights. For example, as illustrated in FIG. 1, the second cell C12 may be disposed in the first row R11 and the second row R12, the fourth cell C14 may be disposed in the third row R13 and the fourth row R14, and the seventh cell C17 may be disposed in the third to fifth rows R13 to R15. In the present disclosure, multi-height cells disposed consecutively in rows having different heights may be referred to as hyper cells. As will be described later with reference to the drawings, various structures of hyper cells may be provided, whereby both high performance and high density may be simultaneously achieved in the integrated circuit. In addition, the integrated circuit 10 that satisfies desired requirements may be easily designed on account of hyper cells having various structures, thereby improving reliability of the integrated circuit 10.

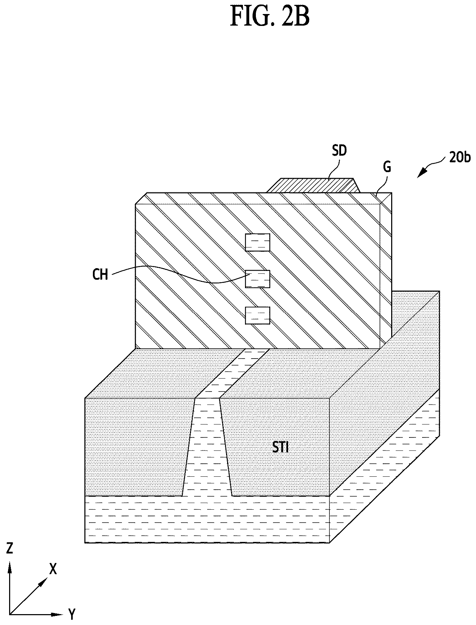

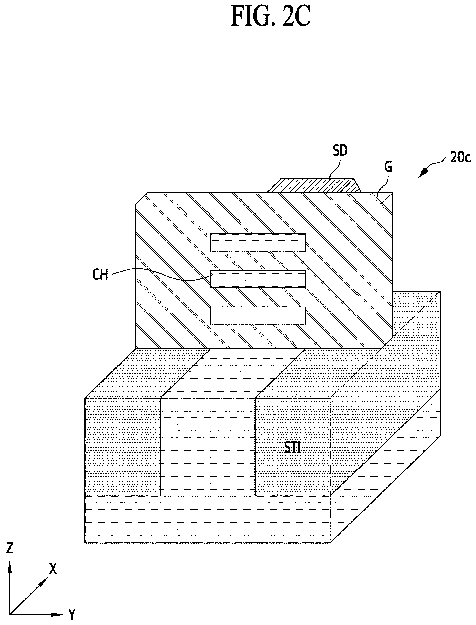

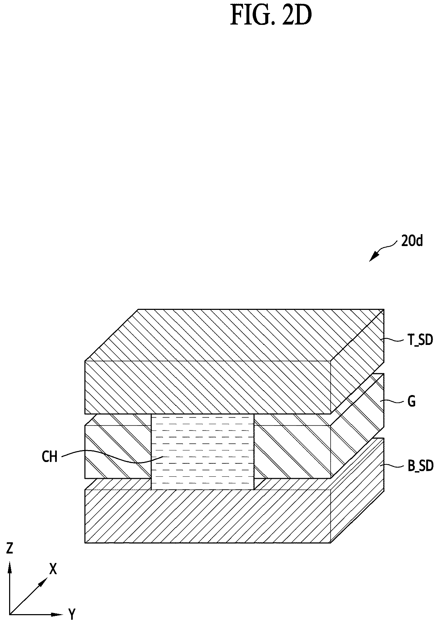

FIGS. 2A, 2B, 2C, and 2D are views illustrating devices according to some implementations. For example, FIG. 2A illustrates a fin field-effect transistor (FinFET) 20a, FIG. 2B illustrates a gate-all-around field-effect transistor (GAAFET) 20b, FIG. 2C illustrates a multi-bridge channel field-effect transistor (MBCFET) 20c, and FIG. 2D illustrates a vertical field-effect transistor (VFET) 20d. For ease of illustration, FIGS. 2A through 2C illustrate examples in which one of two source/drain regions is removed, and FIG. 2D illustrates a cross-section of the VFET 20d taken along a plane parallel to a plane defined by the Y-axis and the Z-axis and passing through a channel CH of the VFET 20d.

Referring to FIG. 2A, the FinFET 20a may be formed by an active pattern (AP) having a fin shape extending in the Y-axis direction between shallow trench isolations (STIs), and a gate G extending in the Y-axis direction. A source/drain SD may be formed on both sides of the gate G, so that the source and the drain may be spaced apart from each other in the X-axis direction. An insulating film may be formed between a channel CH and the gate G. In some implementations, the FinFET 20a may be formed by a plurality of APs spaced apart from each other in the Y-axis direction and the gate G.

As used herein, an "active pattern" (AP) refers to a patterned semiconductor region that is electrically active and configured to form part of a transistor structure. The active pattern may define a channel region and source/drain regions of a transistor and may be formed in or on a semiconductor substrate. Depending on the applied technology, the active pattern may include a planar active region, a fin structure, a nanosheet structure, or other semiconductor features suitable for device formation. The active pattern is distinguished from isolation regions and may be doped to have a desired conductivity type.

Referring to FIG. 2B, the GAAFET 20b may be formed by APs, for example, nanowires, spaced apart from each other in the Z-axis direction and extending in the X-axis direction, and a gate G extending in the Y-axis direction. A source/drain SD may be formed on both sides of the gate G, so that the source and the drain may be spaced apart from each other in the X-axis direction. An insulating film may be formed between a channel CH and the gate G. The number of nanowires included in the GAAFET 20b is not limited to the example illustrated in FIG. 2B.

Referring to FIG. 2C, the MBCFET 20c may be formed by APs, for example, nanosheets, spaced apart from each other in the Z-axis direction and extending in the X-axis direction, and a gate G extending in the Y-axis direction. A source/drain SD may be formed on both sides of the gate G, so that the source and the drain may be spaced apart from each other in the X-axis direction. An insulating film may be formed between a channel CH and the gate G. The number of nanosheets included in the MBCFET 20c is not limited to the example illustrated in FIG. 2C.

Referring to FIG. 2D, the VFET 20d may include a top source/drain T_SD and a bottom source/drain B_SD spaced apart from each other in the Z-axis direction, with a channel CH therebetween. The VFET 20d may include a gate G surrounding the perimeter of the channel CH between the top source/drain T_SD and the bottom source/drain B_SD. An insulating film may be formed between the channel CH and the gate G.

It is noted that devices included in an integrated circuit are not limited to the examples of FIGS. 2A through 2D. For example, the integrated circuit may include a ForkFET having a structure in which an N-type transistor and a P-type transistor are closer to each other by separating nanosheets for the P-type transistor and nanosheets for the N-type transistor with a dielectric wall. The integrated circuit may also include not only FETs, such as a complementary field-effect transistor (CFET), a negative capacitance field-effect transistor (NCFET), and a carbon nanotube (CNT) FET, but also a bipolar junction transistor.

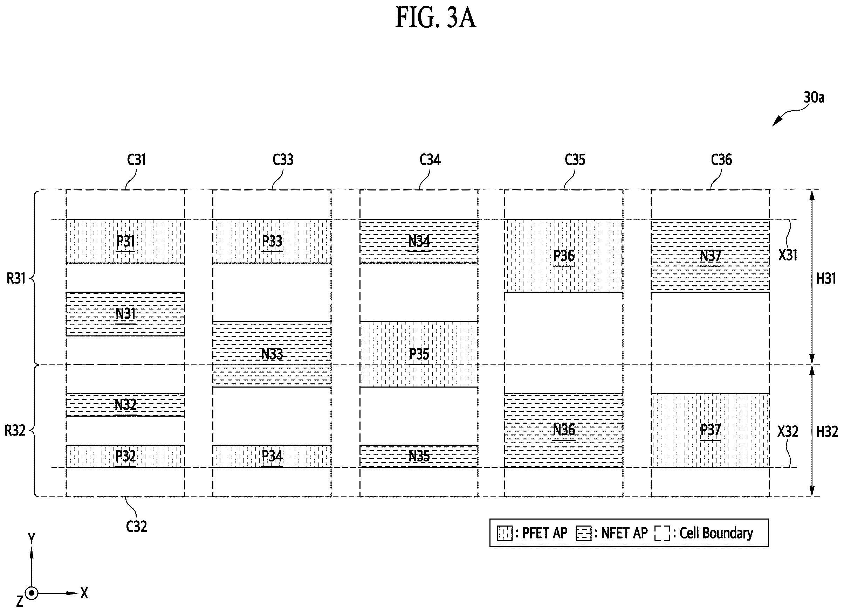

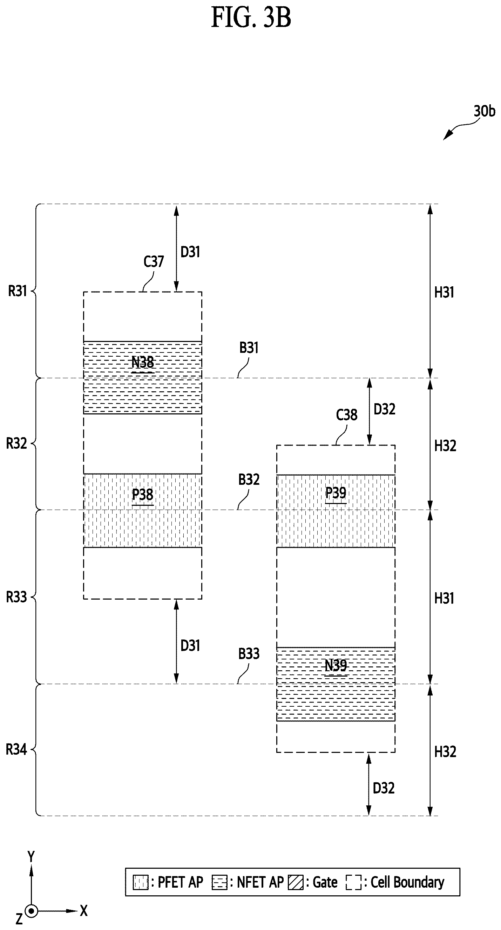

FIGS. 3A and 3B are diagrams illustrating examples of layouts of integrated circuits according to some implementations. For example, FIG. 3A illustrates an integrated circuit 30a including first to sixth cells C31 to C36 disposed in a first row R31 and a second row R32 adjacent to each other, and FIG. 3B illustrates an integrated circuit 30b including a seventh cell C37 and an eighth cell C38 disposed in consecutive first to fourth rows R31 to R34. In FIGS. 3A and 3B, the first cell C31 and the second cell C32 may be single-height cells, whereas the third to eighth cells C33 to C38 may be hyper cells. The first to eighth cells C31 to C38 are illustrated as adjacent to one another for ease of illustration in FIGS. 3A and 3B, but may be spaced farther apart from each other in the X-axis direction than as shown in FIGS. 3A and 3B. In FIGS. 3A and 3B, a first height H31 may be greater than a second height H32 (i.e., H31 > H32). Hereinafter, redundant description with respect to FIGS. 3A and 3B will be omitted.

Referring to FIG. 3A, the integrated circuit 30a may have a mixed row structure including the first row R31 having the first height H31 and the second row R32 having the second height H32.

The first cell C31 disposed in the first row R31 may include a first p-channel field-effect transistor (PFET) AP P31 and a first n-channel field-effect transistor (NFET) AP N31 extending in the X-axis direction. The second cell C32 disposed in the second row R32 may include a second PFET AP P32 and a second NFET AP N32 extending in the X-axis direction. A PFET AP may form a PFET by intersecting with a gate (or gate electrode) extending in the Y-axis direction, and an NFET AP may form an NFET by intersecting with the gate extending in the Y-axis direction. As illustrated in FIG. 3A, the first NFET AP N31 and the second NFET AP N32 may be adjacent to each other in the Y-axis direction.

Accordingly, in some implementations, one or more AP in the first row R31 and one or more AP in the second row 32 have a first conductivity type (e.g., n-type), while one or more AP in the first row R31 and one or more AP in the second row 32 have a second conductivity type (e.g., p-type). As used herein, a "conductivity type" refers to a characteristic of a semiconductor region determined by a type of dopant impurity introduced into the semiconductor material, which establishes a majority charge carrier. A semiconductor region having a first conductivity type may be doped such that electrons are the majority carriers, while a semiconductor region having a second conductivity type may be doped such that holes are the majority carriers. The first and second conductivity types may correspond to n-type and p-type conductivity, respectively, although the present disclosure is not limited thereto.

The third cell C33 may include a third PFET AP P33 extending in the X-axis direction in the first row R31, a fourth PFET AP P34 extending in the X-axis direction in the second row R32, and a third NFET AP N33 extending in the X-axis direction along the border between the first row R31 and the second row R32. In some implementations, the third NFET AP N33 may extend in the X-axis direction across the border between the first row R31 and the second row R32 (e.g., one portion of the third NFET AP N33 may be in the first row R31, and another portion of the third NFET AP N33 may be in the second row R32). In some implementations, the third NFET AP N33 may have a greater width (i.e., a length in the Y-axis direction) than each of the APs included in the first cell C31 and the second cell C32. Accordingly, an NFET may have a high current driving capability in the third cell C33, and the third cell C33 may have a high operation speed. In some implementations, the third NFET AP N33 may be asymmetric with respect to the boundary between the first row R31 and the second row R32. In some implementations, the third PFET AP P33 may have the same width as the first PFET AP P31, and the fourth PFET AP P34 may have the same width as the second PFET AP P32.

The fourth cell C34 may include a fourth NFET AP N34 extending in the X-axis direction in the first row R31, a fifth NFET AP N35 extending in the X-axis direction in the second row R32, and a fifth PFET AP P35 extending in the X-axis direction along the boundary between the first row R31 and the second row R32. In some implementations, the fifth PFET AP P35 may have a greater width than each of the APs included in the first cell C31 and the second cell C32. Accordingly, a PFET may have a high current driving capability in the fourth cell C34, and the fourth cell C34 may have a high operation speed. In some implementations, the fifth PFET AP P35 may be asymmetric with respect to the boundary between the first row R31 and the second row R32. In some implementations, the fourth NFET AP N34 may have the same width as the first NFET AP N31, and the fifth NFET AP N35 may have the same width as the second NFET AP N32.

The fifth cell C35 may include a sixth PFET AP P36 extending in the X-axis direction in the first row R31 and a sixth NFET AP N36 extending in the X-axis direction in the second row R32. Each of the sixth PFET AP P36 and the sixth NFET AP N36 may have a greater width than each of the APs included in the first cell C31 and the second cell C32. Accordingly, a PFET and an NFET may have high current driving capabilities in the fifth cell C35, and the fifth cell C35 may have a high operation speed. In some implementations, the sixth PFET AP P36 and the sixth NFET AP N36 may have the same width.

The sixth cell C36 may include a seventh NFET AP N37 extending in the X-axis direction in the first row R31 and a seventh PFET AP P37 extending in the X-axis direction in the second row R32. Each of the seventh PFET AP P37 and the seventh NFET AP N37 may have a greater width than each of the APs included in the first cell C31 and the second cell C32. Accordingly, a PFET and an NFET may have high current driving capabilities in the sixth cell C36, and the sixth cell C36 may have a high operation speed. In some implementations, the seventh PFET AP P37 and the seventh NFET AP N37 may have the same width.

In some implementations, APs disposed in the same row may be aligned with each other in the X-axis direction. For example, as shown in FIG. 3A, the first PFET AP P31, the third PFET AP P33, the fourth NFET AP N34, the sixth PFET AP P36, and the seventh NFET AP N37 disposed in the first row R31 may be aligned with a first line X31 parallel to the X-axis in the first row R31. In some implementations, unlike the example of FIG. 3A, the sixth PFET AP P36 and the seventh NFET AP N37 may not be aligned with the first line X31, and distances by which the sixth PFET AP P36 and the seventh NFET AP N37 are spaced apart from a boundary (e.g., an outer boundary) of the first row R31 in the Y-axis direction may greater than distances by which the first PFET AP P31, the third PFET AP P33, and the fourth NFET AP N34 are spaced apart from the boundary of the first row R31 in the Y-axis direction. Further, the second PFET AP P32, the fourth PFET AP P34, the fifth NFET AP N35, the sixth NFET AP N36, and the seventh PFET AP P37 disposed in the second row R32 may be aligned with a second line X32 parallel to the X-axis in the second row R32. In some implementations, unlike the example of FIG. 3A, the sixth NFET AP N36 and the seventh PFET AP P37 may not be aligned with the second line X32, and distances by which the sixth NFET AP N36 and the seventh PFET AP P37 are spaced apart from a boundary (e.g., an outer boundary) of the second row R32 in the Y-axis direction may greater than distances by which the second PFET AP P32, the fourth PFET AP P34, and the fifth NFET AP N35 are spaced apart from the boundary of the second row R32 in the Y-axis direction.

Referring to FIG. 3B, the integrated circuit 30b may have a mixed row structure including a first row R31 and a third row R33 having the first height H31 and a second row R32 and a fourth row R34 having the second height H32. The integrated circuit 30b may include power rails for supplying power to cells. For example, power rails extending in the X-axis direction may be disposed on a first boundary B31 between the first row R31 and the second row R32 and a third boundary B33 between the third row R33 and the fourth row R34 to supply negative supply voltages VSS to NFETs. In addition, a power rail extending in the X-axis direction may be disposed on a second boundary B32 between the second row R32 and the third row R33 to supply a positive supply voltage VDD to PFETs.

The seventh cell C37 disposed in the first to third rows R31 to R33 may include an eighth NFET AP N38 extending in the X-axis direction on the first boundary B31 and an eighth PFET AP P38 extending in the X-axis direction on the second boundary B32. In some implementations, each of the eighth NFET AP N38 and the eighth PFET AP P38 may have a greater width than an AP included in each of the single-height cells. In some implementations, the eighth NFET AP N38 and the eighth PFET AP P38 may have the same width. In some implementations, the seventh cell C37 may be spaced apart by a first distance D31 from the boundary of the first row R31, and the seventh cell C37 may be spaced apart by the first distance D31 from the third boundary B33. In some implementations, the first distance D31 may be half the first height H31.

The eighth cell C38 disposed in the second to fourth rows R32 to R34 may include a ninth PFET AP P39 extending in the X-axis direction on the second boundary B32 and the ninth NFET AP N39 extending in the X-axis direction on the third boundary B33. In some implementations, each of the ninth NFET AP N39 and the ninth PFET AP P39 may have a greater width than an AP included in each of the single-height cells. In some implementations, the ninth NFET AP N39 and the ninth PFET AP P39 may have the same width. In some implementations, the eighth cell C38 may be spaced apart by a second distance D32 from the first boundary B31, and the eighth cell C38 may be spaced apart by the second distance D32 from a boundary of the fourth row R34. In some implementations, the second distance D32 may be half the second height H32.

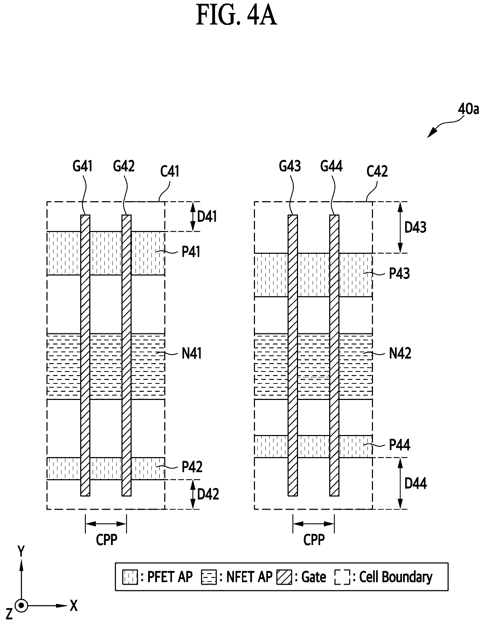

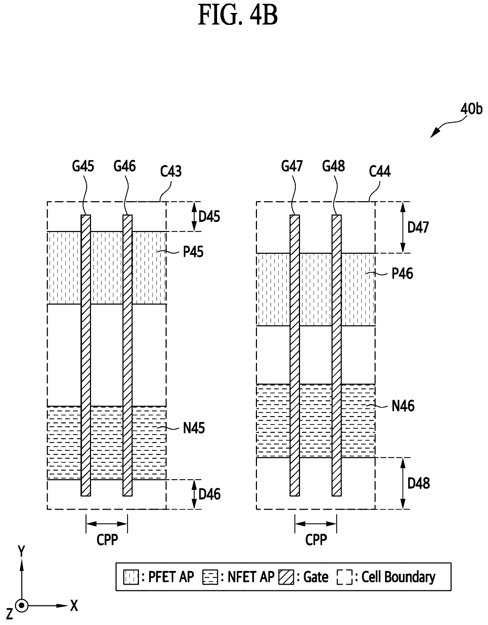

FIGS. 4A and 4B are diagrams illustrating examples of layouts of integrated circuits according to some implementations. For example, FIG. 4A illustrates an integrated circuit 40a including hyper cells each including three APs extending in the X-axis direction. FIG. 4B illustrates an integrated circuit 40b including hyper cells each including two APs extending in the X-axis direction. Although FIGS. 4A and 4B illustrate hyper cells each including two gates extending in the Y-axis direction, the configurations of hyper cells and the gates are not limited thereto. Hereinafter, redundant description with respect to FIGS. 4A and 4B will be omitted.

Referring to FIG. 4A, the integrated circuit 40a may include a first cell C41 and a second cell C42. The first cell C41 may include a first PFET AP P41, a first NFET AP N41, and a second PFET AP P42 extending in the X-axis direction. Further, the first cell C41 may include a first gate G41 and a second gate G42 extending in the Y-axis direction. As illustrated in FIG. 4A, a pitch between gates adjacent to each other, such as the first gate G41 and the second gate G42, may be referred to as a contacted poly pitch (CPP). As illustrated in FIG. 4A, the first PFET AP P41 may be spaced apart from a boundary of the first cell C41 by a first distance D41, and the second PFET AP P42 may be spaced apart from a boundary of the first cell C41 by a second distance D42. In some implementations, the first distance D41 and the second distance D42 may be the same.

The second cell C42 may include a third PFET AP P43, a second NFET AP N42, and a fourth PFET AP P44 extending in the X-axis direction. Further, the second cell C42 may include a third gate G43 and a fourth gate G44 extending in the Y-axis direction. In some implementations, the third PFET AP P43, the second NFET AP N42, and the fourth PFET AP P44 may overlap the first PFET AP P41, the first NFET AP N41, and the second PFET AP P42, respectively, in the X-axis direction. As illustrated in FIG. 4A, the third PFET AP P43 may be spaced apart from a boundary of the second cell C42 by a third distance D43, and the fourth PFET AP P44 may be spaced apart from a boundary of the second cell C42 by a fourth distance D44. In some implementations, the third distance D43 and the fourth distance D44 may be the same.

A transistor may be affected by its surroundings. For example, a transistor may have different structures depending on its surroundings due to semiconductor processes, and may also be electrically and/or chemically affected by its surroundings. Such an effect of surroundings on a transistor may be referred to as a local layout effect (LLE). In some implementations, to reduce an LLE on a transistor, a cell may include APs spaced far apart from the boundaries of the cell. For example, in FIG. 4A, the third distance D43 may be greater than the first distance D41, and accordingly, an LLE on a PFET formed by the third PFET AP P43 may be weaker than an LLE on a PFET formed by the first PFET AP P41. Likewise, the fourth distance D44 may be greater than the second distance D42, and accordingly, an LLE on a PFET formed by the fourth PFET AP P44 may be weaker than an LLE on a PFET formed by the second PFET AP P42. Unlike the example of FIG. 3A, the first PFET AP P41 and the third PFET AP P43 may not be aligned with each other in the X-axis direction.

Referring to FIG. 4B, the integrated circuit 40b may include a third cell C43 and a fourth cell C44. The third cell C43 may include a fifth PFET AP P45 and a fifth NFET AP N45 extending in the X-axis direction. Further, the third cell C43 may include a fifth gate G45 and a sixth gate G46 extending in the Y-axis direction. As illustrated in FIG. 4B, the fifth PFET AP P45 may be spaced apart from a boundary of the third cell C43 by a fifth distance D45, and the fifth NFET AP N45 may be spaced apart from a boundary of the third cell C43 by a sixth distance D46. In some implementations, the fifth distance D45 and the sixth distance D46 may be the same.

The fourth cell C44 may include a sixth PFET AP P46 and a sixth NFET AP N46 extending in the X-axis direction. Further, the fourth cell C44 may include a seventh gate G47 and an eighth gate G48 extending in the Y-axis direction. In some implementations, the sixth PFET AP P46 and the sixth NFET AP N46 may overlap the fifth PFET AP P45 and the fifth NFET AP N45, respectively, in the X-axis direction. As illustrated in FIG. 4B, the sixth PFET AP P46 may be spaced apart from a boundary of the fourth cell C44 by a seventh distance D47, and the sixth NFET AP N46 may be spaced apart from a boundary of the fourth cell C44 by an eighth distance D48. In some implementations, the seventh distance D47 and the eighth distance D48 may be the same. In FIG. 4B, the seventh distance D47 may be greater than the fifth distance D45, and accordingly, an LLE on a PFET formed by the sixth PFET AP P46 may be weaker than an LLE on a PFET formed by the fifth PFET AP P45. Likewise, the eighth distance D48 may be greater than the sixth distance D46, and accordingly, an LLE on an NFET formed by the sixth NFET AP N46 may be weaker than an LLE on an NFET formed by the fifth NFET AP N45. Unlike the example of FIG. 3A, the fifth PFET AP P45 and the sixth PFET AP P46 may not be aligned with each other in the X-axis direction.

A transistor may have an extended AP and a low threshold voltage for high operation speed, while having a high threshold voltage for reduced power consumption. Accordingly, transistors having different threshold voltages may be provided, and each of the transistors may belong to a single threshold voltage device group. In some implementations, a threshold voltage of a transistor may be adjusted by controlling the doping concentration of an AP and/or a source/drain or by controlling a work function of a gate. One threshold voltage device group may define a pair of a PFET threshold voltage and an NFET threshold voltage.

In some implementations, a hyper cell may include transistors belonging to different threshold voltage device groups. For example, in the first cell C41 of FIG. 4A, the PFET formed by the first PFET AP P41 and the PFET formed by the second PFET AP P42 may have different threshold voltages. Furthermore, the PFET formed by the first PFET AP P41 and the NFET formed by the first NFET AP N41 may belong to different threshold groups. In addition, in the third cell C43 of FIG. 4B, the PFET formed by the fifth PFET AP P45 and the NFET formed by the fifth NFET AP N45 may belong to different threshold groups.

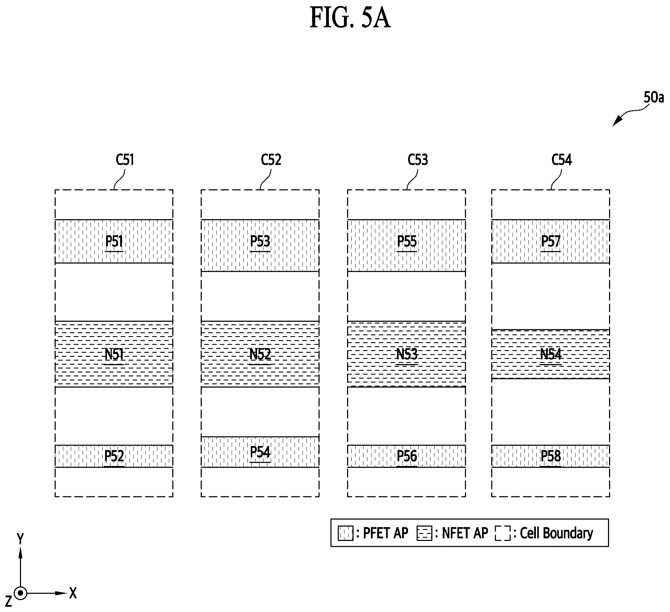

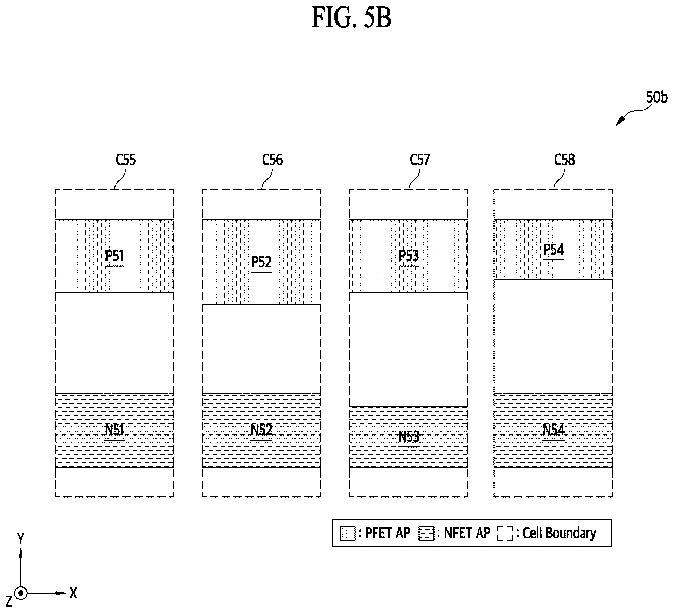

FIGS. 5A and 5B are diagrams illustrating examples of layouts of integrated circuits according to some implementations. For example, FIG. 5A illustrates a layout of an integrated circuit 50a including hyper cells each including three APs extending in the X-axis direction, and FIG. 5B illustrates a layout of an integrated circuit 50b including hyper cells each including two APs extending in the X-axis direction. As illustrated in FIGS. 5A and 5B, an integrated circuit may include hyper cells each including APs having different widths. Accordingly, the degree of design freedom of an integrated circuit may increase, and an integrated circuit may be optimally designed. Redundant description with respect to FIGS. 5A and 5B will be omitted.

Referring to FIG. 5A, the integrated circuit 50a may include first to fourth cells C51 to C54. The first cell C51 may include a first PFET AP P51, a second PFET AP P52, and a first NFET AP N51 extending in the X-axis direction. The second cell C52 may include a third PFET AP P53, a fourth PFET AP P54, and a second NFET AP N52 extending in the X-axis direction. In some implementations, the third PFET AP P53 may have a greater width than the first PFET AP P51, the fourth PFET AP P54 may have a greater width than the second PFET AP P52, and the second NFET AP N52 may have the same width as the first NFET AP N51.

The third cell C53 may include a fifth PFET AP P55, a sixth PFET AP P56, and a third NFET AP N53 extending in the X-axis direction. In some implementations, the fifth PFET AP P55 may have a greater width than the first PFET AP P51, the sixth PFET AP P56 may have the same width as the second PFET AP P52, and the third NFET AP N53 may have the same width as the first NFET AP N51.

The fourth cell C54 may include a seventh PFET AP P57, an eighth PFET AP P58, and a fourth NFET AP N54 extending in the X-axis direction. In some implementations, the seventh PFET AP P57 may have the same width as the first PFET AP P51, the eighth PFET AP P58 may have the same width as the second PFET AP P52, and the fourth NFET AP N54 may have a smaller width than the first NFET AP N51.

Referring to FIG. 5B, the integrated circuit 50b may include fifth to eighth cells C55 to C58. The fifth cell C55 may include a first PFET AP P51 and a first NFET AP N51 extending in the X-axis direction. The sixth cell C56 may include a second PFET AP P52 and a second NFET AP N52 extending in the X-axis direction. In some implementations, the second PFET AP P52 may have a greater width than the first PFET AP P51, and the second NFET AP N52 may have the same width as the first NFET AP N51.

The seventh cell C57 may include a third PFET AP P53 and a third NFET AP N53 extending in the X-axis direction. In some implementations, the third PFET AP P53 may have the same width as the first PFET AP P51, and the third NFET AP N53 may have a smaller width than the first NFET AP N51. The eighth cell C58 may include a fourth PFET AP P54 and a fourth NFET AP N54 extending in the X-axis direction. In some implementations, the fourth PFET AP P54 may have a smaller width than the first PFET AP P51, and the fourth NFET AP N54 may have the same width as the first NFET AP N51.

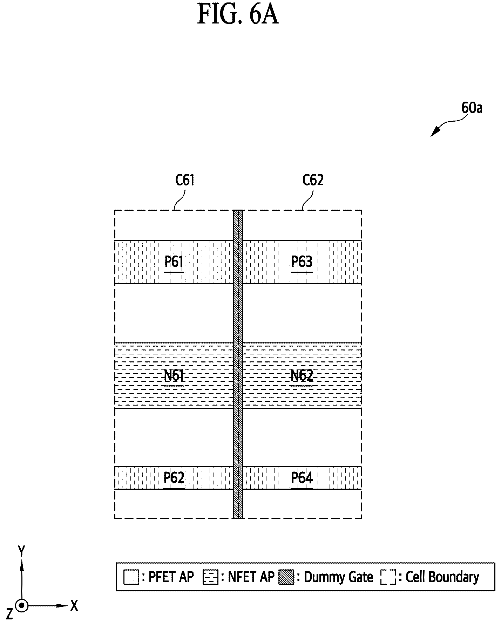

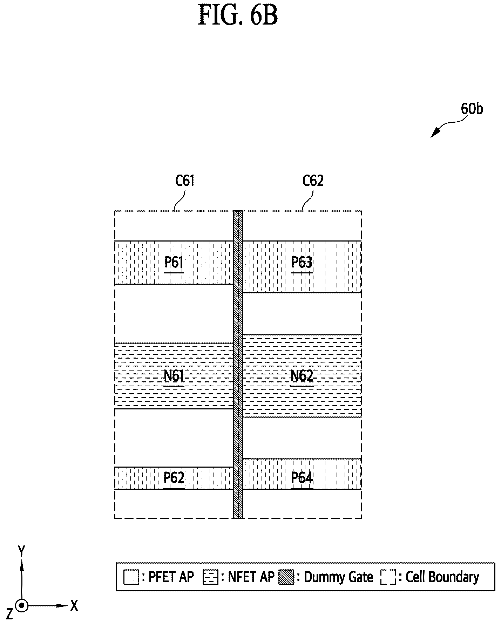

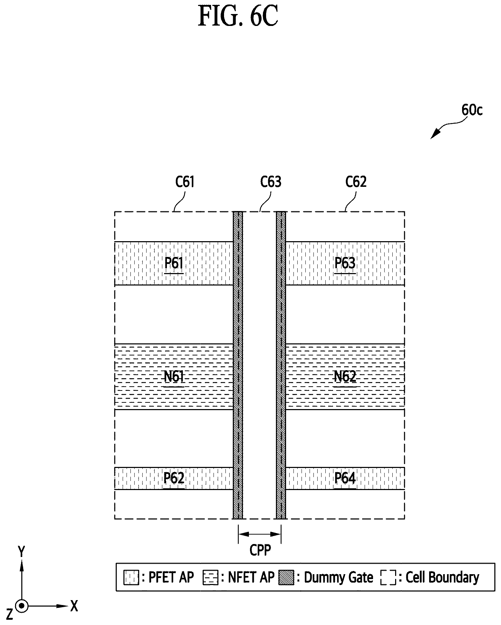

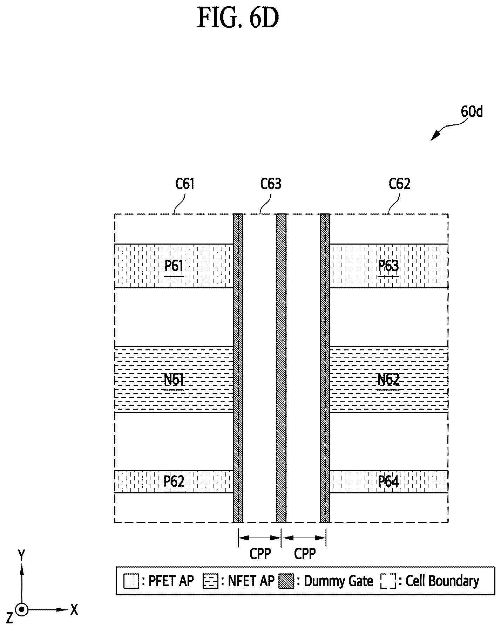

FIGS. 6A, 6B, 6C, and 6D are diagrams illustrating examples of layouts of integrated circuits according to some implementations. For example, FIGS. 6A through 6D illustrate integrated circuits 60a, 60b, 60c and 60d each including a hyper cell which include three APs extending along the X-axis and which are aligned with each other in the X-axis direction.

Referring to FIG. 6A, a first cell C61 and a second cell C62 may be adjacent to each other in the X-axis direction. The first cell C61 may include a first PFET AP P61, a first NFET AP N61, and a second PFET AP P62 extending in the X-axis direction. In addition, the second cell C62 may include a third PFET AP P63, a second NFET AP N62, and a fourth PFET AP P64 extending in the X-axis direction. The first PFET AP P61 and the third PFET AP P63 may have the same width. The first NFET AP N61 and the second NFET AP N62 may have the same width. The second PFET AP P62 and the fourth PFET AP P64 may have the same width. A dummy gate (or single diffusion break (SDB)) may extend in the Y-axis direction along the boundary between the first cell C61 and the second cell C62, and the APs of the first cell C61 and the APs of the second cell C62 may be separated from each other by the dummy gate.

Referring to FIG. 6B, a first cell C61 and a second cell C62 may be adjacent to each other in the X-axis direction. The first cell C61 may include a first PFET AP P61, a first NFET AP N61, and a second PFET AP P62 extending in the X-axis direction. In addition, the second cell C62 may include a third PFET AP P63, a second NFET AP N62, and a fourth PFET AP P64 extending in the X-axis direction. The first PFET AP P61 and the third PFET AP P63 may have different widths. The first NFET AP N61 and the second NFET AP N62 may have different widths. The second PFET AP P62 and the fourth PFET AP P64 may have different widths. A dummy gate (or SDB) may extend in the Y-axis direction along the boundary between the first cell C61 and the second cell C62, and the APs of the first cell C61 and the APs of the second cell C62 may be separated from each other by the dummy gate.

Referring to FIG. 6C, a first cell C61 and a second cell C62 may be adjacent to each other in the X-axis direction, with a third cell C63 therebetween. The first cell C61 may include a first PFET AP P61, a first NFET AP N61, and a second PFET AP P62 extending in the X-axis direction. In addition, the second cell C62 may include a third PFET AP P63, a second NFET AP N62, and a fourth PFET AP P64 extending in the X-axis direction. The third cell C63 may remove APs between dummy gates (or SDBs) that extend in the Y-axis direction and are adjacent to each other. That is, the third cell C63 may include a double diffusion break (DDB), and may have a width (i.e., a length in the X-axis direction) of 1 CPP.

Referring to FIG. 6D, a first cell C61 and a second cell C62 may be adjacent to each other in the X-axis direction, with a third cell C63 therebetween. The first cell C61 may include a first PFET AP P61, a first NFET AP N61, and a second PFET AP P62 extending in the X-axis direction. In addition, the second cell C62 may include a third PFET AP P63, a second NFET AP N62, and a fourth PFET AP P64 extending in the X-axis direction. The third cell C63 may remove APs between dummy gates (or SDBs) that extend in the Y-axis direction and are adjacent to each other. That is, the third cell C63 may include a DDB, and may have a width (i.e., a length in the X-axis direction) of 2 CPPs.

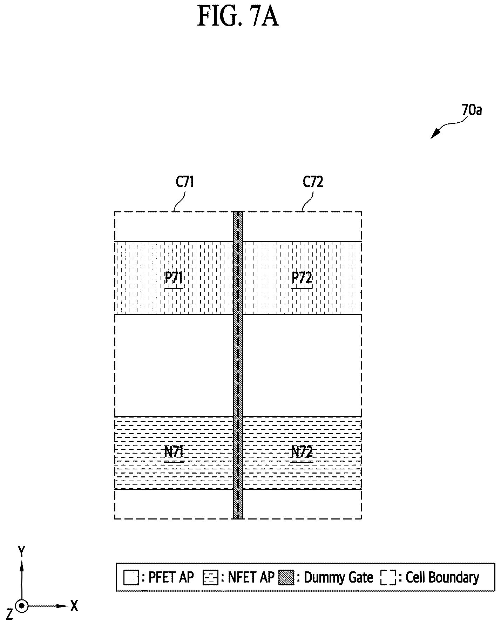

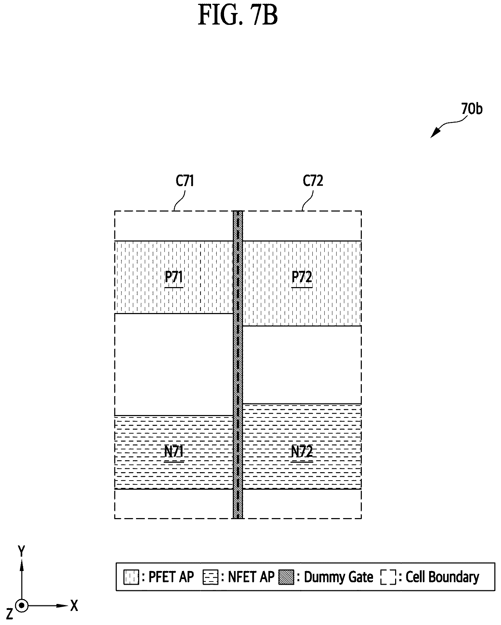

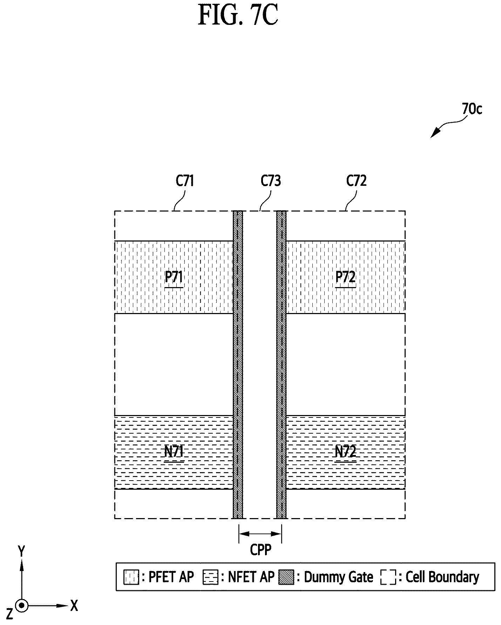

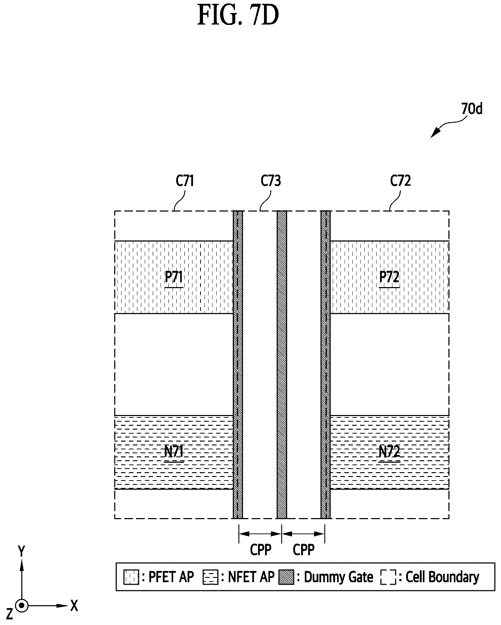

FIGS. 7A, 7B, 7C, and 7D are diagrams illustrating examples of layouts of integrated circuits according to some implementations. For example, FIGS. 7A through 7D illustrate integrated circuits 70a, 70b, 70c and 70d each including a hyper cell which include two APs extending along the X-axis and are aligned with each other in the X-axis direction.

Referring to FIG. 7A, a first cell C71 and a second cell C72 may be adjacent to each other in the X-axis direction. The first cell C71 may include a first PFET AP P71 and a first NFET AP N71 extending in the X-axis direction. In addition, the second cell C72 may include a second PFET AP P72 and a second NFET AP N72 extending in the X-axis direction. The first PFET AP P71 and the second PFET AP P72 may have the same width. The first NFET AP N71 and the second NFET AP N72 may have the same width. A dummy gate (or SDB) may extend in the Y-axis direction along the boundary between the first cell C71 and the second cell C72, and the APs of the first cell C71 and the APs of the second cell C72 may be separated from each other by the dummy gate.

Referring to FIG. 7B, a first cell C71 and a second cell C72 may be adjacent to each other in the X-axis direction. The first cell C71 may include a first PFET AP P71 and a first NFET AP N71 extending in the X-axis direction. In addition, the second cell C72 may include a second PFET AP P72 and a second NFET AP N72 extending in the X-axis direction. The first PFET AP P71 and the second PFET AP P72 may have different widths. The first NFET AP N71 and the second NFET AP N72 may have different widths. A dummy gate (or SDB) may extend in the Y-axis direction along the boundary between the first cell C71 and the second cell C72, and the APs of the first cell C71 and the APs of the second cell C72 may be separated from each other by the dummy gate.

Referring to FIG. 7C, a first cell C71 and a second cell C72 may be adjacent to each other in the X-axis direction, with a third cell C73 therebetween. The first cell C71 may include a first PFET AP P71 and a first NFET AP N71 extending in the X-axis direction. In addition, the second cell C72 may include a second PFET AP P72 and a second NFET AP N72 extending in the X-axis direction. The third cell C73 may remove APs between dummy gates (or SDBs) that extend in the Y-axis direction and are adjacent to each other. That is, the third cell C73 may include a DDB, and may have a width (i.e., a length in the X-axis direction) of 1 CPP.

Referring to FIG. 7D, a first cell C71 and a second cell C72 may be adjacent to each other in the X-axis direction, with a third cell C73 therebetween. The first cell C71 may include a first PFET AP P71 and a first NFET AP N71 extending in the X-axis direction. In addition, the second cell C72 may include a second PFET AP P72 and a second NFET AP N72 extending in the X-axis direction. The third cell C73 may remove APs between dummy gates (or SDBs) that extend in the Y-axis direction and are adjacent to each other. That is, the third cell C73 may include a DDB, and may have a width (i.e., a length in the X-axis direction) of 2 CPPs.

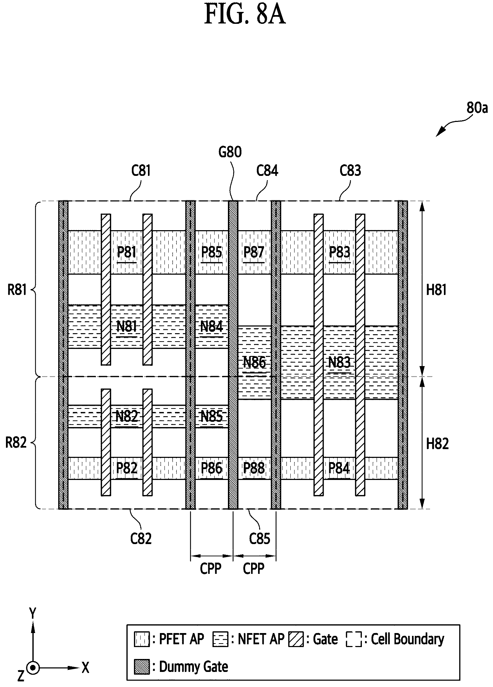

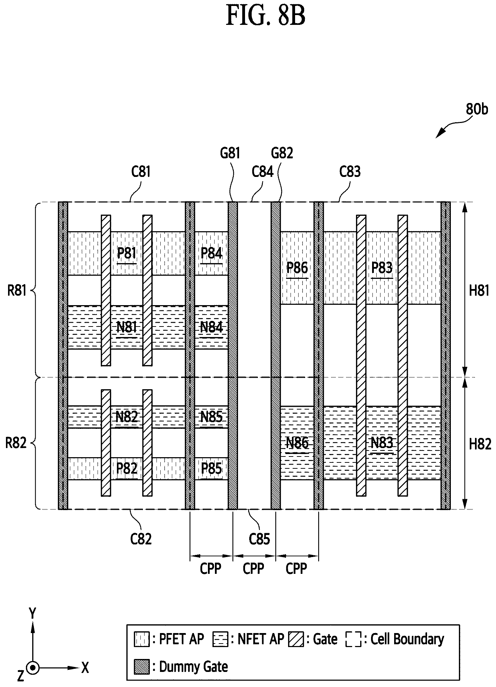

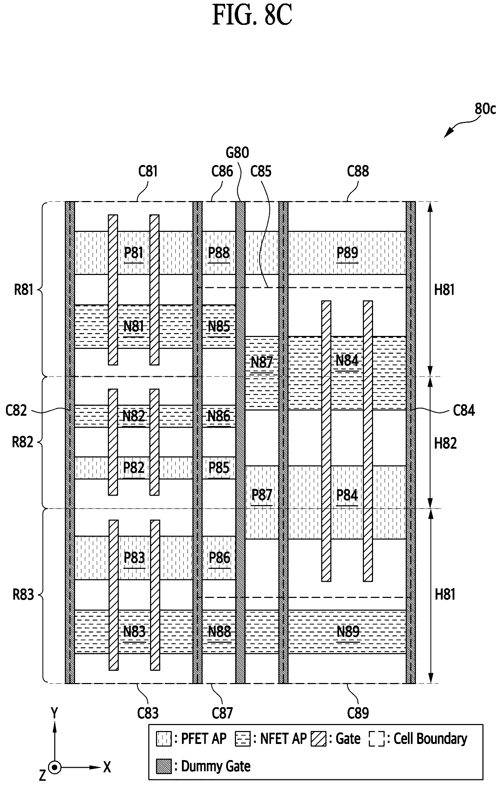

FIGS. 8A, 8B, and 8C are diagrams illustrating examples of layouts of integrated circuits according to some implementations. For example, FIGS. 8A through 8C illustrate examples of layouts of integrated circuits including filler cells between single-height cells and a hyper cell. In FIGS. 8A through 8C, cells may be disposed in a first row R81 having a first height H81, a third row R83 having the first height H81, and a second row R82 having a second height H82, and it is assumed that the first height H81 is greater than the second height H82 (i.e., H81>H82). Redundant description with respect to FIGS. 8A through 8C will be omitted.

Referring to FIG. 8A, an integrated circuit 80a may include first to fifth cells C81 to C85. The first cell C81, which is a single-height cell, may be disposed in the first row R81, and the second cell C82, which is also a single-height cell, may be disposed in the second row R82. As illustrated in FIG. 8A, the first cell C81 may include a first PFET AP P81 and a first NFET AP N81 extending in the X-axis direction, and the second cell C82 may include a second NFET AP N82 and a second PFET AP P82 extending in the X-axis direction. The third cell C83, which is a hyper cell, may be disposed consecutively in the first row R81 and the second row R82. As illustrated in FIG. 8A, the third cell C83 may include a third PFET AP P83, a fourth PFET AP P84, and a third NFET AP N83 extending in the X-axis direction. In some implementations, the first PFET AP P81 and the third PFET AP P83 may have the same width, and the second PFET AP P82 and the fourth PFET AP P84 may have the same width.

In some implementations, filler cells may be disposed between single-height cells and a hyper cell, and the filler cells may interface APs of the single-height cells and APs of the hyper cell. For example, as illustrated in FIG. 8A, the fourth cell C84 may be disposed between the first cell C81 and the third cell C83. The fourth cell C84 may include a fifth PFET AP P85 having the same width as the first PFET AP P81 and a seventh PFET AP P87 having the same width as the third PFET AP P83. Further, the fourth cell C84 may include a fourth NFET AP N84 having the same width as the first NFET AP N81 and a portion of a sixth NFET AP N86 having the same width as the third NFET AP N83. Likewise, the fifth cell C85 may include a fifth NFET AP N85 having the same width as the second NFET AP N82 and a portion of the sixth NFET AP N86 having the same width as the third NFET AP N83. Further, the fifth cell C85 may include a sixth PFET AP P86 having the same width as the second PFET AP P82 and an eighth PFET AP P88 having the same width as the fourth PFET AP P84.

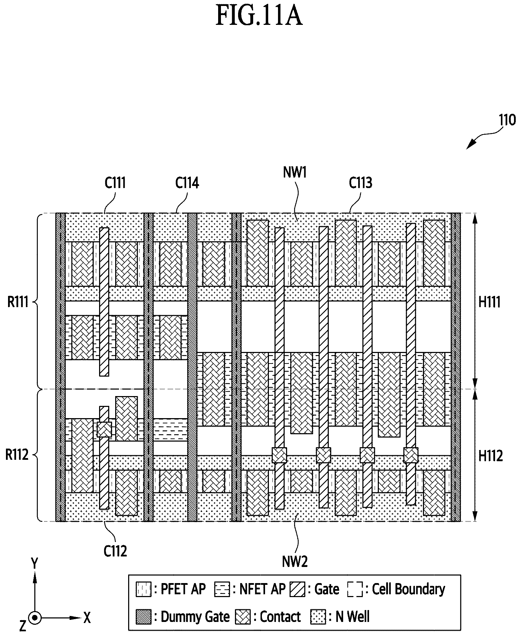

In some implementations, the filler cells may include a diffusion break extending in the Y-axis direction and separating APs from each other. For example, as illustrated in FIG. 8A, the fourth cell C84 and the fifth cell C85 may include a dummy gate G80 extending in the Y-axis direction. The dummy gate G80 may include an insulating material, may separate APs on both sides from each other, and may be referred to as an SDB. As illustrated in FIG. 8A, an SDB extending in the Y-axis direction may be disposed on a boundary of each of the first to fifth cells C81 to C85, and each of the first to fifth cells C81 to C85 may be electrically isolated from its adjacent cell(s). As illustrated in FIG. 8A, the fourth cell C84 and the fifth cell C85 may have a width (i.e., a length in the X-axis direction) of 2 CPPs. In some implementations, like the fourth cell C114 of FIG. 11A, the fourth cell C84 and the fifth cell C85 may be defined as a single filler cell which is a multi-height cell.

Referring to FIG. 8B, an integrated circuit 80b may include first to fifth cells C81 to C85. The first cell C81, which is a single-height cell, may be disposed in the first row R81, and the second cell C82, which is also a single-height cell, may be disposed in the second row R82. As illustrated in FIG. 8B, the first cell C81 may include a first PFET AP P81 and a first NFET AP N81 extending in the X-axis direction, and the second cell C82 may include a second NFET AP N82 and a second PFET AP P82 extending in the X-axis direction. The third cell C83, which is a hyper cell, may be disposed consecutively in the first row R81 and the second row R82. As illustrated in FIG. 8B, the third cell C83 may include a third PFET AP P83 and a third NFET AP N83 extending in the X-axis direction. In some implementations, the third PFET AP P83 may have a greater width than each of the first PFET AP P81 and the second PFET AP P82, and the third NFET AP N83 may have a greater width than each of the first NFET AP N81 and the second NFET AP N82.

As illustrated in FIG. 8B, a fourth cell C84, which is a filler cell in the first row R81, may be disposed between the first cell C81 and the third cell C83. The fourth cell C84 may include a fourth PFET AP P84 having the same width as the first PFET AP P81 and a fourth NFET AP N84 having the same width as the first NFET AP N81. Further, the fourth cell C84 may include a sixth PFET AP P86 having the same width as the third PFET AP P83. Likewise, the fifth cell C85 may include a fifth NFET AP N85 having the same width as the second NFET AP N82 and a fifth PFET AP P85 having the same width as the second PFET AP P82. Further, the fifth cell C85 may include a sixth NFET AP N86 having the same width as the third NFET AP N83.

The fourth cell C84 and the fifth cell C85 may include diffusion breaks extending in the Y-axis direction between a first dummy gate G81 and a second dummy gate G82. As illustrated in FIG. 8B, the diffusion breaks may include an insulating material, may remove APs between the first dummy gate G81 and the second dummy gate G82, and may be referred to as a DDB. As illustrated in FIG. 8B, the fourth cell C84 and the fifth cell C85 may have a width (i.e., a length in the X-axis direction) of 3 CPPs. In some implementations, like the fourth cell C114 of FIG. 11A, the fourth cell C84 and the fifth cell C85 may be defined as a single filler cell which is a multi-height cell.

Referring to FIG. 8C, an integrated circuit 80c may include first to ninth cells C81 to C89. The first to third cells C81 to C83 may be single-height cells. The first cell C81 may include a first PFET AP P81 and a first NFET AP N81, the second cell C82 may include a second NFET AP N82 and a second PFET AP P82, and the third cell C83 may include a third PFET AP P83 and a third NFET AP N83. The fourth cell C84, which is a hyper cell, may be disposed in first to third rows R81 to R83. The fourth cell C84 may include a fourth NFET AP N84 and a fourth PFET AP P84.

In some implementations, filler cells may be disposed between the fourth cell C84 and the single-height cells. For example, as illustrated in FIG. 8C, the fifth cell C85 may be disposed in the first to third rows R81 to R83. In some implementations, the fifth cell C85 may have the same height (i.e., the same length in the Y-axis direction) as the fourth cell C84. The fifth cell C85 may include fifth to seventh NFET APs N85 to N87 and fifth to seventh PFET APs P85 to P87. In some implementations, the fifth NFET AP N85, the sixth NFET AP N86, the fifth PFET AP P85, and the sixth PFET AP P86 may have the same widths as the first NFET AP N81, the second NFET AP N82, the second PFET AP P82, and the third PFET AP P83, respectively. In some implementations, the seventh NFET AP N87 and the seventh PFET AP P87 may have the same widths as the fourth NFET AP N84 and the fourth PFET AP P84, respectively. In the fifth cell C85, a dummy gate G80 may extend in the Y-axis direction and separate APs from each other.

Filler cells having a height which is half the height of a row may be disposed adjacent to the fourth cell C84. For example, as illustrated in FIG. 8C, the sixth to ninth cells C86 to C89 may be disposed adjacent to the fourth cell C84. The sixth cell C86 may include an eighth PFET AP P88, the seventh cell C87 may include an eighth NFET AP N88, the eighth cell C88 may include a ninth PFET AP P89, and the ninth cell C89 may include a ninth NFET AP N89. In some implementations, the first PFET AP P81, the eighth PFET AP P88, and the ninth PFET AP P89 may have the same width. In some implementations, the third NFET AP N83, the eighth NFET AP N88, and the ninth NFET AP N89 may have the same width.

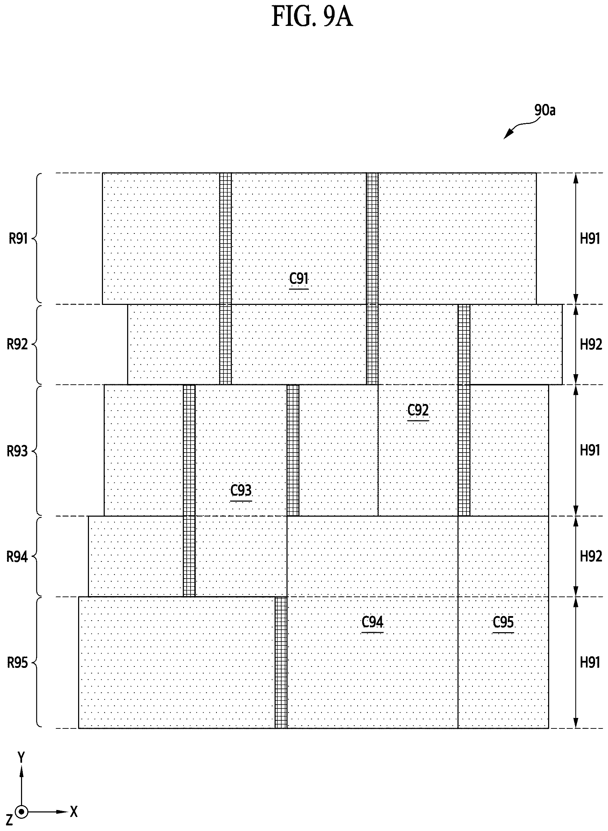

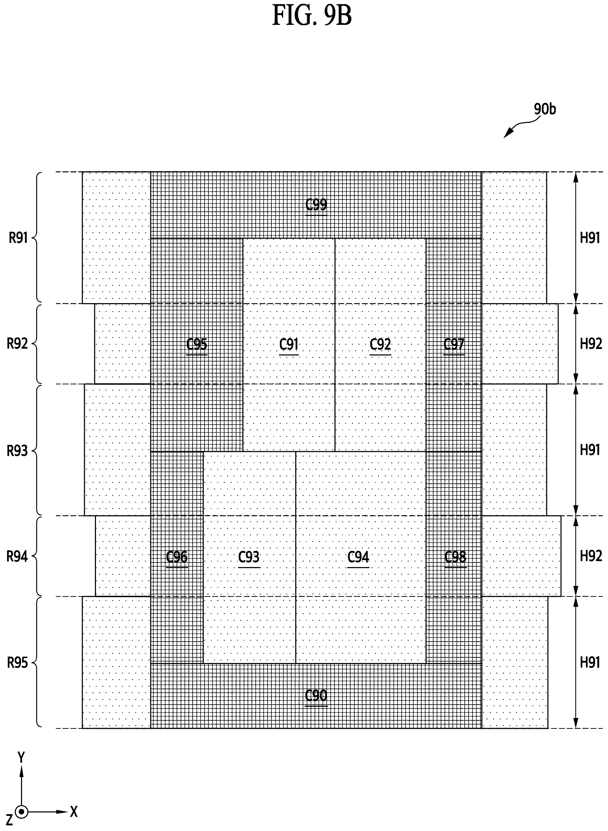

FIGS. 9A and 9B are diagrams illustrating examples of layouts of integrated circuits according to some implementations. For example, FIG. 9A illustrates a layout of an integrated circuit 90a including hyper cells disposed consecutively in two rows, and FIG. 9B illustrates an integrated circuit 90b including hyper cells disposed consecutively in three rows. In some implementations, a single integrated circuit may include hyper cells disposed consecutively in two rows and hyper cells disposed consecutively in three rows. As illustrated in FIGS. 9A and 9B, cells may be disposed in first to fifth rows R91 to R95 extending in the X-axis direction. The first row R91, the third row R93, and the fifth row R95 may have a first height H91, and the second row R92 and the fourth row R94 may have a second height H92 smaller than the first height H91.

Referring to FIG. 9A, the integrated circuit 90a may include first to fifth cells C91 to C95, which are hyper cells. Like the fourth cell C94 and the fifth cell C95, hyper cells may be aligned with each other in the X-axis direction and may be adjacent to each other. Like the first cell C91 and the second cell C92, hyper cells may be adjacent to each other in the X-axis direction in a single row. Like the second cell C92 and the fourth cell C94, hyper cells may be aligned with each other in the Y-axis direction and may be adjacent to each other. Like the first cell C91 and the third cell C93, hyper cells adjacent to each other in the Y-axis direction may not be aligned with each other in the Y-axis direction. Like the second cell C92 and the fifth cell C95, the corners of hyper cells may meet each other.

Referring to FIG. 9B, the integrated circuit 90b may include first to fourth cells C91 to C94, which are hyper cells. Further, the integrated circuit 90b may include fifth to tenth cells C95 to C99 and C90, which are filler cells, between hyper cells and single-height cells. The fifth to eighth cells C95 to C98 may be multi-height cells, whereas the ninth cell C99 and the tenth cell C90 may be half-height cells, each having a height that is half the height of a row. Like the first cell C91 and the second cell C92, hyper cells may be aligned with each other in the X-axis direction and may be adjacent to each other. Like the second cell C92 and the fourth cell C94, hyper cells may be aligned with each other in the Y-axis direction and may be adjacent to each other. Like the first cell C91 and the third cell C93, hyper cells adjacent to each other in the Y-axis direction may not be aligned with each other in the Y-axis direction.

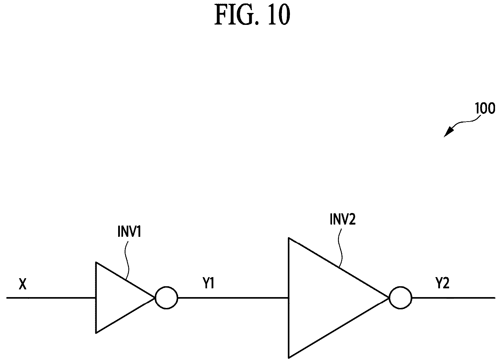

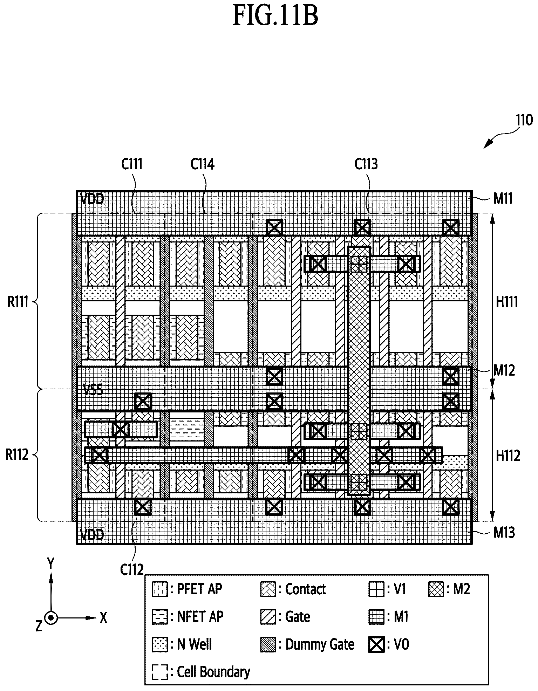

FIG. 10 is a diagram illustrating circuits included in an integrated circuit 100 according an implementation. Referring to FIG. 10, the integrated circuit 100 may include a first inverter INV1 and a second inverter INV2. The first inverter INV1 may generate a first output Y1 by inverting an input X, and the second inverter INV2 may generate a second output Y2 by inverting the first output Y1. The first inverter INV1 may include relatively small-sized transistors for low input capacitance, while the second inverter INV2 may include relatively large-sized transistors for low output impedance. As will be described below with reference to FIGS. 11A and 11B, the first inverter INV1 may be included in the integrated circuit 100 as a single-height cell, and the second inverter INV2 may be included in the integrated circuit 100 as a hyper cell.

FIGS. 11A and 11B are views illustrating examples of a layout of an integrated circuit 110 according to some implementations. For example, FIGS. 11A and 11B illustrate examples of a layout of the integrated circuit 100 of FIG. 10. FIG. 11A illustrates APs, gates, and contacts in an integrated circuit 110, and FIG. 11B additionally illustrates patterns of vias and wiring layers in the integrated circuit 110. In FIGS. 11A and 11B, cells may be disposed in a first row R111 having a first height H111 and a second row R112 having a second height H112, and it is assumed that the first height H111 is greater than the second height H112 (i.e., H111>H112).

Referring to FIG. 11A, wells and APs may extend in the X-axis direction. PFET APs may extend in the X-axis direction in the wells, and NFET APs may extend in the X-axis direction on a substrate. Gates may extend in the Y-axis direction, and sources/drains may be formed between the gates. Contacts may be disposed on the sources/drains and the gates. For ease of illustration, the sources/drains are omitted from FIGS. 11A and 11B.

The integrated circuit 110 may include cells corresponding to the first inverter INV1 and the second inverter INV2 of FIG. 10, respectively. Referring to FIG. 11A, the integrated circuit 110 may include first to fourth cells C111 to C114, and the second cell C112 and the third cell C113 may correspond to the first inverter INV1 and the second inverter INV2 of FIG. 10, respectively. The second cell C112 may be disposed in the second row R112 having the second height H112, and may include relatively small-sized transistors. The third cell C113, which is a hyper cell, may be disposed consecutively in the first row R111 and the second row R112, and may include transistors in a larger size than the transistors included in the first cell C111 disposed in the first row R111. Accordingly, the second cell C112 may have a small input capacitance, and the third cell C113 may have a small output impedance.

The fourth cell C114, which is a filler cell, may be disposed between the first cell C111 and the second cell C112 and the third cell C113. As described above with reference to FIG. 8A, the fourth cell C114 may include APs, and a diffusion break extending in the Y-axis direction and separating the APs from each other. As illustrated in FIG. 11A, a first well NW1 and a second well NW2 may extend in the X-axis direction on the substrate. In some implementations, the substrate may be of a p-type and may be biased with a negative supply voltage VSS, whereas the first well NW1 and the second well NW2 may be of an n-type and may be biased with a positive supply voltage VDD.

Referring to FIG. 11B, vias of a first via layer V0 may be disposed on contacts, and the vias of the first via layer V0 may be connected to patterns of a first wiring layer M1. Vias of a second via layer V1 may be disposed on the patterns of the first wiring layer M1, and the vias of the second via layer V1 may be connected to patterns of a second wiring layer M2. As illustrated in FIG. 11B, the input X, the first output Y1, and the second output Y2 of FIG. 10 may be routed. In FIG. 11B, electrodes of the transistors included in the first cell C111 may not be routed, and the first cell C111 may be referred to as a dummy cell.

The integrated circuit 110 may include power rails extending in the X-axis direction on the boundaries of the first row R111 and the second row R112. For example, as illustrated in FIG. 11B, in the first wiring layer M1, a first pattern M11 may extend in the X-axis direction on a boundary of the first row R111, and may supply a positive supply voltage VDD to the cells. In the first wiring layer M1, a second pattern M12 may extend in the X-axis direction on the boundary between the first row R111 and the second row R112, and may supply a negative supply voltage VSS to the cells. In the first wiring layer M1, a third pattern M13 may extend in the X-axis direction on a boundary of the second row R112, and may supply a positive supply voltage VDD to the cells.

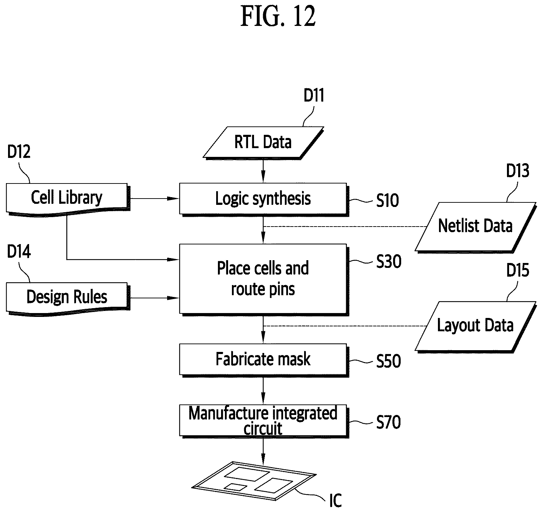

FIG. 12 is a flowchart illustrating a method of manufacturing an integrated circuit IC according to an implementation. In detail, the flowchart of FIG. 12 illustrates an example of a method of manufacturing an integrated circuit IC including cells. As illustrated in FIG. 12, the method of manufacturing an integrated circuit IC may include a plurality of operations S10, S30, S50, and S70.

A cell library (or standard cell library) D12 may include information about cells, for example, information about functions, characteristics, layouts, and the like. In some implementations, the integrated circuit IC may have a mixed row structure, and the cell library D12 may define single-height cells having different heights. Furthermore, the cell library D12 may define a hyper cell disposed consecutively in rows having different heights, and a filler cell disposed between a single-height cell and a hyper cell. As described above with reference to the drawings, the cell library D12 may define hyper cells having various structures, and accordingly, the integrated circuit IC may be designed to have optimal performance and efficiency.

Design rules D14 may include requirements that a layout of the integrated circuit IC should comply with. For example, the design rules D14 may include requirements on a spacing between patterns in the same layer, a minimum width of patterns, and a routing direction of a wiring layer. In some implementations, the design rules D14 may define a minimum width of an AP, and a minimum spacing between APs.

In operation S10, a logic synthesis operation of generating netlist data D13 from register transfer level (RTL) data D11 may be performed. For example, a semiconductor design tool (e.g., a logic synthesis tool) may perform logic synthesis with reference to the cell library D12 from the RTL data D11 written as a hardware description language (HDL), such as VHSIC Hardware Description Language (VHDL) or Verilog, thereby generating the netlist data D13 including a bitstream or a netlist. The netlist data D13 may correspond to an input of place and route described below. Herein, the netlist data D13 may be referred to as input data.

In operation S30, cells may be placed, and pins may be routed. For example, a semiconductor design tool (e.g., P&R Tool) may place cells used in the netlist data D13 with reference to the cell library D12 and the design rules D14. In some implementations, the semiconductor design tool may place rear patterns in a rear wiring layer. Pins of the placed cells may be routed. For example, the semiconductor design tool may generate interconnections that electrically connect output pins and input pins of the placed cells. While routing the pins, the semiconductor design tool may move the placed cells or replace the placed cells with cells having different layouts. In addition, the semiconductor design tool may generate interconnections connected to nodes to which a positive supply voltage is applied or nodes to which a negative supply voltage is applied, to provide power to functional cells. The interconnections may include vias of a via layer and/or patterns of a wiring layer.

The semiconductor design tool may generate layout data D15 that defines the placed cells and the generated interconnections, that is, a layout of the integrated circuit IC. The layout data D15 may have, for example, a format such as Graphic Design System II (GDSII), and may include geometric information of cells and interconnections. The semiconductor design tool may refer to the design rules D14 while routing the pins of the cells. The layout data D15 may correspond to an output of place and route, and may be referred to as output data herein. Operation S30 may be referred to as a method of designing an integrated circuit.

In operation S50, an operation of fabricating a mask may be performed. For example, optical proximity correction (OPC) for compensating for distortion phenomena due to the characteristics, such as refraction, of light in photolithography may be applied to the layout data D15. Based on the data to which OPC is applied, patterns on a mask may be defined to form patterns disposed in a plurality of layers, and at least one mask (or photomask) for forming patterns of each of the plurality of layers may be fabricated. In some implementations, the layout of the integrated circuit IC may be modified in a limited manner in operation S50. Modifying the integrated circuit IC in a limited manner in operation S50 may be referred to as design polishing, which is a post-process for optimizing the structure of the integrated circuit IC.

In operation S70, an operation of manufacturing the integrated circuit IC may be performed. For example, the integrated circuit IC may be manufactured by patterning the plurality of layers using the at least one mask fabricated in operation S50. A front-end-of-line (FEOL) may include, for example, planarizing and cleaning a wafer, forming trenches, forming wells, forming gate electrodes, and forming a source and a drain. Through the FEOL, individual devices, such as transistors, capacitors, and resistors, may be formed on a substrate. In addition, a back-end-of-line (BEOL) may include, for example, silicidating gate, source, and drain regions, adding dielectrics, planarizing, forming holes, adding metal layers, forming vias, and forming a passivation layer. Through the BEOL, the individual devices, such as the transistors, the capacitors, and the resistors, may be interconnected. In some implementations, a middle-of-line (MOL) may be performed between the FEOL and the BEOL, and contacts may be formed on the individual devices. Thereafter, the integrated circuit IC may be packaged in a semiconductor package and used as a component in various applications.

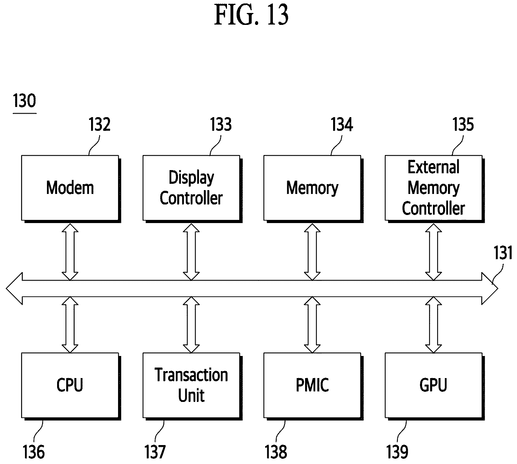

FIG. 13 is a block diagram illustrating a system-on-chip (SoC) 130 according to an implementation. The SoC 130, which is a semiconductor device, may include an integrated circuit according to an example implementation of the present disclosure. The SoC 130 implements complex blocks, such as intellectual property (IP), that perform various functions, on a single chip, and may include the hyper cells described above with reference to the drawings. Accordingly, the SoC 130 may have optimal performance and efficiency and may have high reliability. Referring to FIG. 13, the SoC 130 may include a modem 132, a display controller 133, a memory 134, an external memory controller 135, a central processing unit (CPU) 136, a transaction unit 137, a power management integrated circuit (PMIC) 138, and a graphics processing unit (GPU) 139. The functional blocks of the SoC 130 may communicate with each other through a system bus 131.

The CPU 136 capable of controlling the operation of the SoC 130 at a top-level hierarchy may control the operations of the other functional blocks, for example, the modem 132, the display controller 133, the memory 134, the external memory controller 135, the transaction unit 137, the PMIC 138, and the GPU 139. The modem 132 may demodulate signals received from outside the SoC 130, or may modulate signals generated inside the SoC 130 and transmit the modulated signals to the outside. The external memory controller 135 may control an operation of transmitting and receiving data to and from an external memory device connected to the SoC 130. For example, a program and/or data stored in the external memory device may be provided to the CPU 136 or the GPU 139 under the control of the external memory controller 135. The GPU 139 may execute program instructions related to graphics processing. The GPU 139 may receive graphic data through the external memory controller 135, or may transmit graphic data processed by the GPU 139 to outside the SoC 130 through the external memory controller 135. The transaction unit 137 may monitor data transactions of the respective functional blocks, and the PMIC 138 may control power supplied to the respective functional blocks under the control of the transaction unit 137. The display controller 133 may control a display (or display device) external to the SoC 130 to transmit data generated inside the SoC 130 to the display. The memory 134 may include a non-volatile memory, such as electrically erasable programmable read-only memory (EEPROM) or flash memory, or may include a volatile memory, such as dynamic random-access memory (DRAM) or static random-access memory (SRAM).

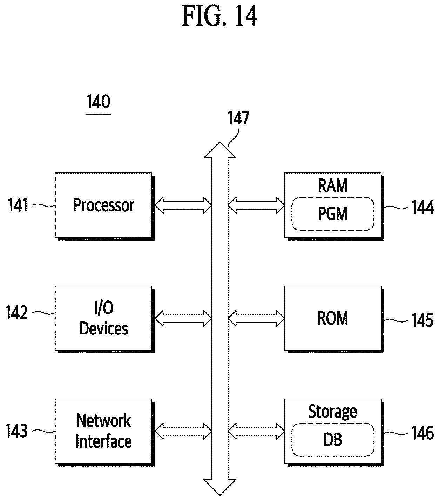

FIG. 14 is a block diagram illustrating a computing system 140 including a memory configured to store a program according to an implementation. A method of designing an integrated circuit, for example, at least a portion of the operations of the flowchart described above, may be performed by the computing system (or computer) 140.

The computing system 140 may be a stationary computing system, such as a desktop computer, a workstation, or a server, or may be a portable computing system, such as a laptop computer. As illustrated in FIG. 14, the computing system 140 may include a processor 141, input/output (I/O) devices 142, a network interface 143, a random-access memory (RAM) 144, a read-only memory (ROM) 145, and a storage 146. The processor 141, the I/O devices 142, the network interface 143, the RAM 144, the ROM 145, and the storage 146 may be connected to a bus 147, and may communicate with each other through the bus 147.

The processor 141 may be referred to as a processing unit, and may include at least one core capable of executing a predetermined instruction set (e.g., Intel Architecture-32 (IA-32), 64-bit extension IA-32, x86-64, PowerPC, Sparc, MIPS, ARM, IA-64), such as, for example, a micro-processor, an application processor (AP), a digital signal processor (DSP), or a GPU. For example, the processor 141 may access a memory, such as the RAM 144 or the ROM 145, through the bus 147, and execute instructions stored in the RAM 144 or the ROM 145.

The RAM 144 may store a program PGM, or at least a portion thereof, for the method of designing an integrated circuit according to an implementation of the present disclosure, and the program PGM may cause the processor 141 to perform the method of designing an integrated circuit, for example, at least a portion of the operations included in the method of FIG. 12. That is, the program PGM may include a plurality of instructions executable by the processor 141, and the plurality of instructions included in the program PGM may cause the processor 141 to perform at least a portion of the operations included in the flowchart described above.

The storage 146 may not lose data stored therein even when the power supplied to the computing system 140 is cut off. For example, the storage 146 may include a non-volatile memory device, or a storage medium such as a magnetic tape, an optical disk, or a magnetic disk. In addition, the storage 146 may be detachable from the computing system 140. The storage 146 may store the program PGM according to an implementation of the present disclosure, and the program PGM or at least a portion thereof may be loaded from the storage 146 into the RAM 144 before the program PGM is executed by the processor 141. Alternatively, the storage 146 may store a file written in a programming language, and a program PGM or at least a portion thereof generated by a compiler from the file may be loaded into the RAM 144. Furthermore, as illustrated in FIG. 14, the storage 146 may store a database DB, and the database DB may include information required for designing an integrated circuit, for example, information about designed blocks, the cell library D12, and/or the design rules D14 of FIG. 12.

The storage 146 may also store data to be processed by the processor 141 or data processed by the processor 141. That is, the processor 141 may generate data by processing data stored in the storage 146 according to the program PGM, and store the generated data in the storage 146. For example, the storage 146 may store the RTL data D11, the netlist data D13, and/or the layout data D15 of FIG. 12.

The I/O devices 142 may include an input device, such as a keyboard or a pointing device, and an output device, such as a display device or a printer. For example, a user may trigger execution of the program PGM by the processor 141 through the I/O devices 142, input the RTL data D11 and/or the netlist data D13 of FIG. 12, or may check the layout data D15 of FIG. 12.

The network interface 143 may provide access to a network external to the computing system 140. For example, the network may include multiple computing systems and communication links, and the communication links may include wired links, optical links, wireless links, or other types of links.

While the present disclosure contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Example implementations have been described above with reference to the drawings. Although specific terms have been used herein to describe the example implementations, such terms are merely used for the purpose of describing the technical scope of the present disclosure and are not intended to limit the meaning or to restrict the scope of the disclosure as set forth in the claims. Accordingly, it will be apparent to those skilled in the art that various modifications and other equivalents can be made to the example implementations.

## Claims

1. An integrated circuit (30a) comprising:
a first cell (C31) disposed in a first row (R31), the first row (R31) (i) having a first width (H31) and (ii) extending in a first direction (X), the first cell (C31) comprising a first active pattern (AP) (P31) and a second AP (N31) both extending in the first direction (X);
a second cell (C32) disposed in a second row (R32), the second row (R32) (i) having a second width (H32) different from the first width (H31), (ii) extending in the first direction (X), and (iii) being adjacent to the first row (R31) in a second direction (Y) intersecting the first direction (X), the second cell (C32) comprising a third AP (N32) and a fourth AP (P32) both extending in the first direction (X); and
a third cell (C36) disposed consecutively in the first row (R31) and the second row (R32),
wherein the third cell (C36) comprises:
a fifth AP (N37) having a greater width than a width of each of the first AP (P31) and the second AP (N31) and extending in the first direction (X) in the first row (R31); and
a sixth AP (P37) having a greater width than a width of each of the third AP (N32) and the fourth AP (P32) and extending in the first direction (X) in the second row (R32).

2. The integrated circuit (30a) of claim 1,
wherein the second AP (N31) and the third AP (N32) each extend in the first direction (X) between the first AP (P31) and the fourth AP (P32) and have a first conductivity type, and
the first AP (P31) and the fourth AP (P32) have a second conductivity type.

3. The integrated circuit (30a) of claim 2,
wherein a distance (D43) by which the fifth AP (N37) is spaced apart from a boundary of the first row (R31) in the second direction (Y) is greater than a distance (D41) by which the first AP (P31) is spaced apart from the boundary of the first row (R31) in the second direction (Y).

4. The integrated circuit (30a) of claim 2 or claim 3,
wherein a distance (D43) by which the sixth AP (P37) is spaced apart from a boundary of the second row (R33) in the second direction (Y) is greater than a distance (D41) by which the fourth AP (P32) is spaced apart from the boundary of the second row (R32) in the second direction (Y).

5. The integrated circuit (30a) of any preceding claim,
wherein the third cell (C36) comprises:
a first gate extending in the second direction (Y) and forming a first transistor by intersecting the fifth AP (P37); and
a second gate extending in the second direction (Y) and forming a second transistor by intersecting the sixth AP (P37),
wherein the first transistor and the second transistor respectively belong to different threshold voltage device groups.

6. The integrated circuit (30a) of claim 5,
wherein the fifth AP (N37) has a doping concentration different from a doping concentration of the sixth AP (P37).

7. The integrated circuit (30a) of claim 5 or claim 6,
wherein the first gate has a work function different from a work function of the second gate.

8. The integrated circuit (30a) of any preceding claim, comprising:
a fourth cell between the first cell (C31) and the third cell (C36) in the first row (R31),
wherein the fourth cell comprises:
a seventh AP having a same width as the width of the first AP (P31) and extending in the first direction (X); and
an eighth AP having a same width as the width of the fifth AP (N37) and extending in the first direction (X).

9. The integrated circuit (30a) of claim 8,
wherein the fourth cell comprises a first dummy gate (G80) (i) extending in the second direction (Y) between the seventh AP and the eighth AP and (ii) comprising an insulating material.

10. The integrated circuit (30a) of claim 9,
wherein the first dummy gate (G80) is adjacent to a second dummy gate (G80) extending in the second direction (Y) at a boundary between the first cell (C31) and the fourth cell, and adjacent to a third dummy gate (G80) extending in the second direction (Y) at a boundary between the third cell (C36) and the fourth cell.

11. The integrated circuit (30a) of any preceding claim, comprising:
a fifth cell disposed consecutively in the first row (R31) and the second row (R32),
wherein the fifth cell comprises:
a ninth AP having a greater width than the width of each of the first AP (P31) and the second AP (N31) and extending in the first direction (X) in the first row (R31); and
a tenth AP having a greater width than the width of each of the third AP (N32) and the fourth AP (P32) and extending in the first direction (X) in the second row (R32),
wherein the ninth AP has a width different from the width of the fifth AP (N37), and/or the tenth AP has a width different from the width of the sixth AP (P37).

12. An integrated circuit (30a) comprising:
a first cell (C31) disposed in a first row (R31), the first row (R31) (i) having a first width (H31) and (ii) extending in a first direction (X), the first cell (C31) comprising a first active pattern (AP) (P31) and a second AP (N31) both extending in the first direction (X);
a second cell (C32) disposed in a second row (R32), the second row (R32) (i) having a second width (H32) different from the first width (H31), (ii) extending in the first direction (X), and (iii) being adjacent to the first row (R31) in a second direction (Y) intersecting the first direction (X), the second cell (C32) comprising a third AP (N32) and a fourth AP (P32) both extending in the first direction (X); and
a third cell (C36) disposed consecutively in the first row (R31) and the second row (R32), the third cell (C36) comprising a fifth AP (N37) overlapping the first AP (P31) in the first direction (X) and extending in the first direction (X),
wherein the second AP (N31) and the third AP (N32) each extend in the first direction (X) between the first AP (P31) and the fourth AP (P32), and
wherein the fifth AP (N37) is spaced apart by a first distance (D43) from a boundary of the first row (R31) in the second direction (Y), the first AP (P31) is spaced apart by a second distance (D41) from the boundary of the first row (R31) in the second direction (Y), and the first distance (D43) is greater than the second distance (D41).

13. The integrated circuit (30a) of claim 12,
wherein the third cell (C36) comprises a sixth AP (P37) overlapping the fourth AP (P32) in the first direction (X) and extending in the first direction (X), and
wherein the sixth AP (P37) is spaced apart by a third distance (D44) from a boundary of the second row (R32) in the second direction (Y), the fourth AP (P32) is spaced apart by a fourth distance (D42) from the boundary of the second row (R32) in the second direction (Y), and the third distance (D44) is greater than the fourth distance (D42).

14. The integrated circuit (30a) of claim 12 or claim 13, comprising:
a fourth cell between the first cell (C31) and the third cell (C36) in the first row (R31),
wherein the fourth cell comprises:
a seventh AP having a same width as a width of the first AP (P31) and extending in the first direction (X); and
an eighth AP having a same width as a width of the fifth AP (N37) and extending in the first direction (X).

15. The integrated circuit (30a) of any of claims 12-14, comprising:
a fifth cell disposed consecutively in the first row (R31) and the second row (R32),
wherein the fifth cell comprises a ninth AP overlapping the first AP (P31) in the first direction (X) and extending in the first direction (X), and
wherein the ninth AP is spaced apart by a fifth distance from the boundary of the first row (R31) in the second direction (Y), and the fifth distance is different from the first distance.
